# EUROPEAN PATENT APPLICATION

(11) **EP 1 376 666 A2**
(43) Date of publication of application: **02.01.2004**
(21) Application number: 03291383.2
(22) Date of filing: 11.06.2003
(51) Int. Cl.: H01L 21/304

(54) **Method of machining silicon wafer**

(30) Priority: 18.06.2002 JP 2002177430
(71) Applicant: SHINKO ELECTRIC INDUSTRIES CO. LTD., Nagano-shi, Nagano 380-0921 (JP)
(72) Inventor: Mashino, Naohiro, c/o Shinko Electric Industries, Nagano-shi, Nagano 380-0921 (JP)
(74) Representative: Quantin, Bruno

(57) **Abstract**

A method of machining a silicon wafer is capable of preventing the generation of cracks, which start from a tapered or bevel portion in the periphery of the thin silicon wafer, when the wafer of a single crystal body is machined into the thin wafer. A plurality of silicon wafers 1 having a bevel portion 2 in the periphery are laminated, the bevel portions 2 in the peripheries of the plurality of laminated silicon wafers are ground at the same time, and a face of each silicon wafer is ground so as to obtain a thin silicon wafer 10.

## Description

### BACKGROUND OF THE INVENTION

### 1. Field of the Invention

The present invention relates to a method of machining a single-crystal silicon wafer used for semiconductor elements or semiconductor substrates. More particularly, the present invention relates to a method of machining a silicon wafer having a bevel portion in the periphery thereof so that the silicon wafer can be formed into a thin silicon wafer.

### 2. Description of the Related Art

A silicon wafer used for a semiconductor element or semiconductor substrate is cut out from a columnar single crystal body to a disk-shape. To stabilize the profile and to make it easy to handle the silicon wafer, the silicon wafer has a bevel portion or chamfered portion (referred to as a bevel portion hereinafter) in its periphery. Thickness of the silicon wafer, which has been cut out from a single crystal body to a disk shape, is usually about 0.7 mm. However, when the silicon wafer is actually used, the thickness of the silicon wafer is reduced, by means of back-grinding, to several tens of µm.

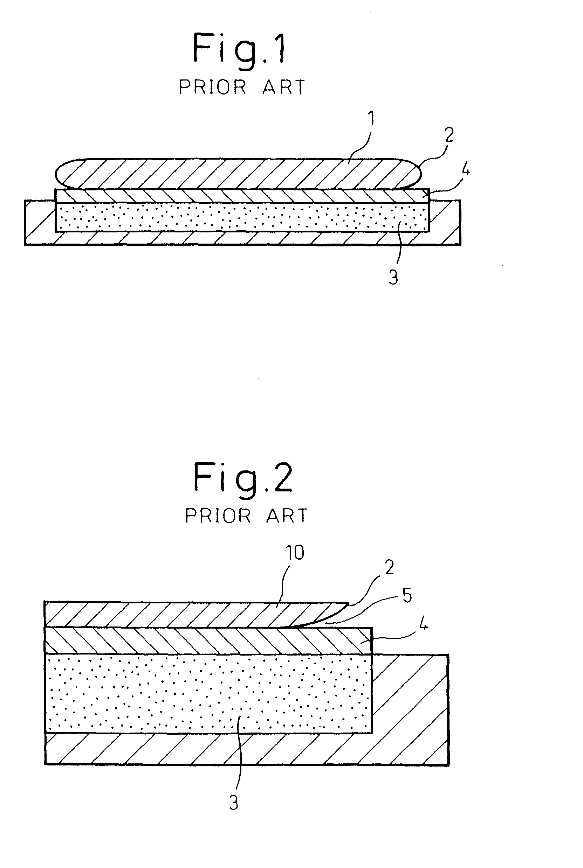

As shown in Figs. 1 and 2, the above thin silicon wafer 1 is conventionally obtained as follows. The silicon wafer having the bevel portion 2 in its periphery is sucked and held by the sucking stage 3. Under the above condition, back-grinding is conducted on the silicon wafer by a grinding device not shown in the drawing so as to reduce the thickness of the silicon wafer to a range from about 0.7 mm to several tens of µm. In this way, the thin silicon wafer 10 is conventionally provided.

In the process of back-grinding, when the silicon wafer is sucked and held by the sucking stage, in some cases, a protective tape 4 is bonded to the side of the silicon wafer coming into contact with the sucking stage.

Irrespective of the existence of the protective tape 4, the following problems may be encountered. In the bevel portion in the periphery of the silicon wafer 1, 10, what is called a "gap portion" 5, in which the silicon wafer does not come into contact with the sucking face of the sucking stage 3, is generated. Therefore, a distribution of the sucking force or sucking pressure, which is generated between the thin silicon wafer 10 and the sucking table 3, cannot be uniform all over the surface of the disk-shaped silicon wafer 10. As a result, after the completion of back-grinding, thickness of the silicon wafer 10 cannot be accurately uniform all over the surface. In the case of handling the thin silicon wafer 10 which has been back-ground, and especially in the case of using the wafer for the three-dimensional mounting in which plating is required and in the case of using the wafer for a silicon interposer, as the thickness of the periphery of the silicon wafer is small and the bevel portion of the wafer is tapered, the wafer tends to crack and handling of the wafer is difficult. In an extreme case, the entire wafer of a crystal body is broken because cracks start from this tapered portion.

The typical prior art is disclosed in the official gazette of Japanese Unexamined Patent Publication No. 62-154614. In this official gazette, there is disclosed a technique in which a laminated body, which is made when mirror faces of a plurality of semiconductor wafers are contacted with each other, is ground so as to simultaneously grind the plurality of semiconductor wafers.

The official gazette of Japanese Unexamined Patent Publication No. 63-307200 discloses the following technique. A surface of the wafer is roughly ground, and then the surface of the wafer is subjected to lapping. Next, a plurality of such the wafers are put on each other, and only the side surfaces of the wafers are etched. Then, the entire faces of the individual wafers are etched and polished.

In the official gazette of Japanese Unexamined Patent Publication No. 5-243208, there is disclosed a technique in which an etching solution is supplied into a processing tank and the corners at the periphery of the silicon wafer are etched.

In the official gazette of Japanese Unexamined Patent Publication No. 10-242439, there is disclosed a technique in which the bonded wafers are oxidized at the temperature of 1000 to 1200°C in the wet atmosphere so as to grow the silicon oxide film and fill a gap portion formed between the bonded wafers and, then, an outer circumferential edge portion of the wafer is ground.

In the official gazette of Japanese Unexamined Patent Publication No. 2001-113447, the following technique is disclosed. In an edge grinding device for grinding an edge of the semiconductor wafer, a minute gap is formed between a rotary column of the grinding mechanism and a laminated body of the semiconductor wafers. A pressured grinding solution is introduced into the minute gap, and grinding is highly accurately and uniformly conducted on an outer circumferential edge portion of the semiconductor wafer.

According to the prior art shown in Figs. 1 and 2, the following problems may be encountered. In the bevel portion in the periphery of the silicon wafer, what is called "a gap portion" is formed which does not come into contact with the sucking face of the sucking stage. Therefore, the distribution of the sucking force or pressure generated between the silicon wafer and the sucking table does not become uniform all over the face of the silicon wafer. Accordingly, the thickness of the thin wafer, which has been back-ground, cannot be uniform. Further, as the bevel portion in the periphery of the silicon wafer is tapered, the wafer tends to crack, and handling of the silicon wafer becomes difficult.

### SUMMARY OF THE INVENTION

Therefore, it is an object of the present invention to provide a method of machining a thin silicon wafer capable of preventing the generation of cracks, which start from a tapered portion in the periphery of the thin silicon wafer, when the wafer of a single crystal body is machined into the thin wafer.

In order to accomplish the above object, according to the present invention, there is provided a method of machining a thin silicon wafer comprising the following steps of: laminating a plurality of silicon wafers each providing with a body having front and back surfaces and a periphery having a bevel portion; grinding the peripheries of the plurality of laminated silicon wafers to remove the bevel portions from the bodies of the silicon wafers; and dividing the laminated silicon wafers into individual silicon wafers and grinding the back surface of each of the silicon wafers to obtain a thin silicon wafer. When the grinding machine side or the sucking table side is rotated, the silicon wafer can be back-ground.

The step of grinding the back surface of each of the silicon wafers can be conducted while the front surface of the silicon wafer is being sucked and held by a sucking table. When the grinding machine side or the sucking table side is rotated, the silicon wafer can be back-ground.

The step of grinding the back surface of each of the silicon wafers can be conducted while a protective film is bonded to the front surface of the silicon wafer which comes into contact with the sucking table. When the above protective film is bonded, it is possible to protect the front surface of the silicon wafer which is not subjected to machining.

The sucking table is made of a porous material and a sucking face of the sucking table has an outer diameter slightly larger than that of the body of the silicon wafer, after the bevel portion is removed. Due to the foregoing, the entire surface of the silicon wafer can be uniformly sucked and held by the sucking table.

### BRIEF DESCRIPTION OF THE DRAWINGS

Fig. 1 is a sectional view showing a state of a silicon wafer before it is back-ground by the conventional thin silicon wafer machining method;
Fig. 2 is a sectional view showing a state of a silicon wafer after it is back-ground by the conventional thin silicon wafer machining method;
Figs. 3(a) and 3(b) are respectively a perspective view and a sectional view of a silicon wafer before it is machined;
Fig. 4 is a perspective view showing a laminated silicon wafers;
Fig. 5 is a perspective view showing a state in which peripheral bevel portions of a plurality of silicon wafers, which are a laminated body, are ground;
Fig. 6 is a perspective view showing a state before and after each silicon wafer is back-ground;
Fig. 7 is a partial sectional view showing a state before a silicon wafer of the present invention is back-ground; and
Fig. 8 is a partial sectional view showing a state in which thickness of a silicon wafer of the present invention is reduced after back-grinding.

### DETAILED DESCRIPTION OF THE PREFERRED EMBODIMENTS

Referring to the accompanying drawings, an embodiment of the present invention will be explained in detail.

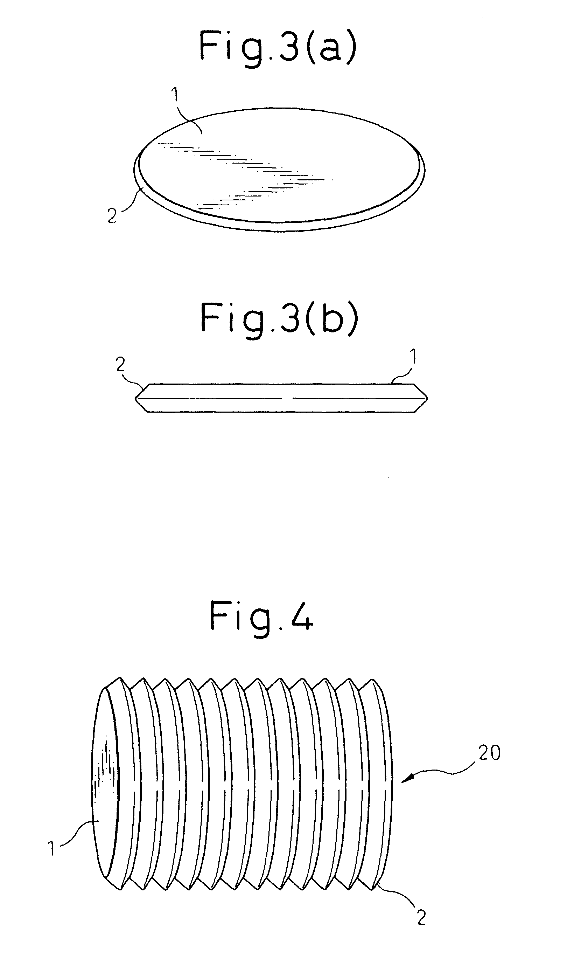

Figs. 3 to 6 are views showing a form of a wafer in each step of machining the thin silicon wafer of the present invention.

Fig. 3(a) is a perspective view of the silicon wafer 1, which is cut out to a disk-shape from a columnar single crystal body used for a semiconductor wafer, wherein this silicon wafer has not been machined yet. At the periphery of the disk-shaped silicon wafer 1, there is provided a bevel portion 2 so that the profile can be stabilized and the handling property can be enhanced. Thickness of this silicon wafer is approximately 0.7 mm. As shown in Fig. 3(b) which shows a cross-section of the bevel portion 2, the peripheral portion is tapered. As shown in Fig. 1, the peripheral portion may be chamfered when it is viewed in the cross sectional view.

Fig. 4 is a view showing a state of the laminated body 20 in which a plurality of silicon wafers 1, which have been cut out into a disk shape and have not yet been back-ground, are laminated on each other in such a manner that the mirror faces of the silicon wafers 1 come into contact with each other. The number of the silicon wafers to be laminated is usually 10 to 50.

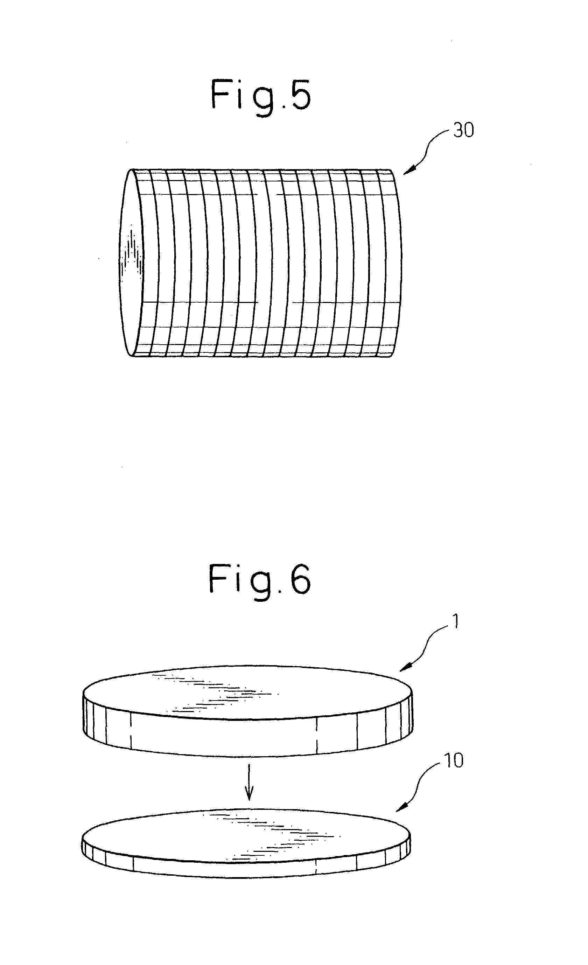

Fig. 5 is a view showing a state in which the bevel portions in the peripheries of a plurality of silicon wafers 1, which are the laminated body 20, are ground at the same time so that the plurality of silicon wafers 1 are formed into a cylindrical laminated body 30. An outer diameter of each silicon wafer 1 is reduced so that the bevel portion in the periphery of the silicon wafer 1 can be completely removed. In the case of grinding, it is possible to use an appropriate cutting device (not shown) having a cutting face parallel with the central axis of the laminated body. Concerning this type grinding device, for example, it is possible to use the device described in the official gazette of Japanese Unexamined Patent Publication No. 2001-113447.

Fig. 6 is a view showing an individual silicon wafer which is separated from the laminated body 30, the peripheral bevel portion of which has been cut off, wherein Fig. 6 shows the states before and after backgrounding. Before back-grinding is conducted, the thickness of the silicon wafer 1 is approximately 0.7 mm as described above. However, when the silicon wafer 1 is subjected to back-grinding, the thickness of the wafer is reduced to about several tens of µm.

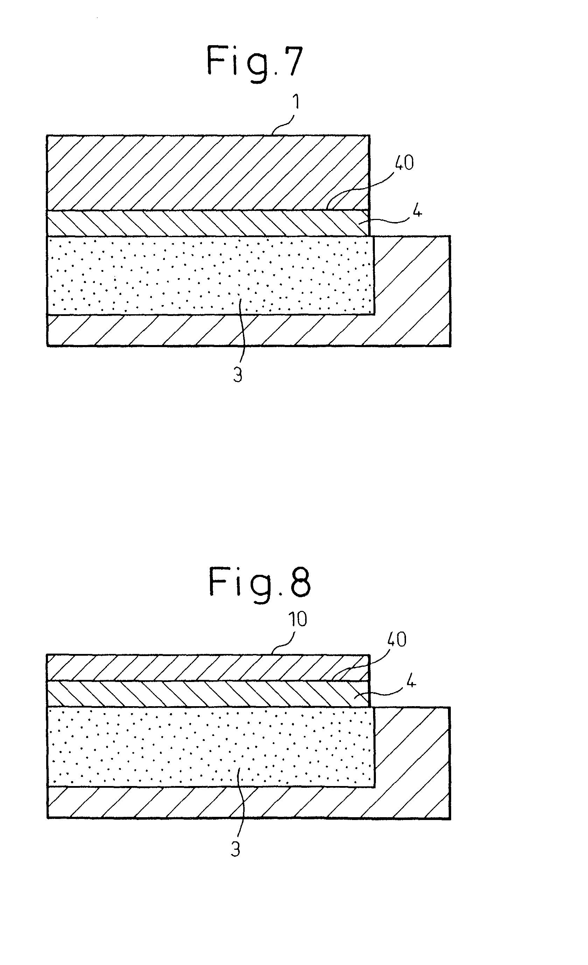

Next, referring to Figs. 7 and 8, the step of back-grinding will be explained in detail below. Fig. 7 is a sectional view of the silicon wafer of the present invention before back-grinding is conducted. Fig. 8 is a sectional view of the silicon wafer of the present invention, after back-grinding is conducted, in which thickness of the silicon wafer is reduced.

When the silicon wafer 1 is sucked and held on the sucking stage 3 of the back-grinding device, the protective tape 4, the size of which is substantially the same as that of the silicon wafer, the peripheral bevel portion of which has been cut, is bonded onto the side 40 of the silicon wafer opposite to the cutting side. Then, the protective tape 4 side of the silicon wafer 1 is set on the sucking stage 3 of the back-grinding device.

The sucking table 3 or the sucking stage is made of porous material. Although not shown in the drawing, a pump to suck air and piping are provided. Therefore, in the case of a sucking action, the entire surface of the sucking stage 3 is uniformly given negative pressure so that a sucking force necessary for holding the silicon wafer 1 on the sucking face of the sucking table can be generated.

The sucking table 3 has a sucking face, the outer diameter of which is a little larger than the outer diameter of the silicon wafer 1, the peripheral bevel portion of which has been ground and removed. Due to the foregoing, it is possible for the sucking table 3 to stably hold the entire face, of the silicon wafer 1, by a sucking force uniformly given to the entire surface.

Even when the above protective tape 4 is not arranged, it possible for the sucking table 3 to hold the silicon wafer 1 on the sucking table 3 and no problems are actually caused in the process of back-grinding. Irrespective of the existence of the protective tape 4, there are no "gap portions" which might be caused by "peripheral protrusions" such as a bevel portion in the periphery of the silicon wafer 1, 10. Therefore, a sucking force or pressure generated between the silicon wafer 1, 10 and the sucking table becomes uniform all over the surface of the silicon wafer 1, 10.
Accordingly, thickness of the silicon wafer can be made uniform, over the entire surface, in the process of back-grinding.

In the case where the thin silicon wafer 10 is handled after the completion of back-grinding, especially in the case of a three-dimensional mounting wafer and a silicon interposer which need to be plated with metal, as no tapered portions, such as a bevel portion, are arranged in the periphery of the silicon wafer, the thin silicon wafer 10 can be very easily handled. Therefore, it is possible to solve the problems of cracks caused in the silicon wafer which is a crystalline body.

The embodiment of the present invention is explained above by referring to the accompanying drawings. However, it should be noted that the present invention is not limited to the above specific embodiment, and variations, modifications and corrections may be made by one skilled in the art without departing from the spirit and scope of the present invention.

As described above, according to the present invention, there is provided a method of machining a thin silicon wafer comprising the steps of: laminating a plurality of silicon wafers having a bevel portion in the periphery; grinding the bevel portions in the peripheries of the plurality of laminated silicon wafers at the same time; and back-grinding a face of each silicon wafer so as to obtain a thin silicon wafer. Therefore, no bevel portions exist in the periphery of the silicon wafer when back-grinding is conducted. Therefore, the silicon wafer is closely contacted with the sucking face of the sucking stage. Accordingly, no floating portions occur between the silicon wafer and the sucking table, and the distribution of sucking pressure generated between the silicon wafer and the sucking table becomes uniform over the entire surface of the silicon wafer. Therefore, it is possible to provide an effect that the thickness of the thin silicon wafer, which has been subjected to back-grinding, can be made uniform and the thin silicon wafer can be easily handled.

## Claims

1. A method of machining a thin silicon wafer comprising the following steps of:
laminating a plurality of silicon wafers each providing with a body having front and back surfaces and a periphery having a bevel portion;
grinding the peripheries of the plurality of laminated silicon wafers to remove the bevel portions from the bodies of the silicon wafers; and
dividing the laminated silicon wafers into individual silicon wafers and grinding the back surface of each of the silicon wafers to obtain a thin silicon wafer.

2. A method as set forth in claim 1, wherein the step of grinding the back surface of each of the silicon wafers is conducted while the front surface of the silicon wafer is being sucked and held by a sucking table.

3. A method as set forth in claim 1, wherein the step of grinding the back surface of each of the silicon wafers is conducted while a protective film is bonded to the front surface of the silicon wafer which comes into contact with the sucking table.

4. A method as set forth in claim 1, wherein the sucking table is made of porous material and a sucking face of the sucking table has an outer diameter slightly larger than that of the body of the silicon wafer after the bevel portion is removed.
